# EUROPEAN PATENT APPLICATION

(11) **EP 4 280 399 A1**
(43) Date of publication of application: **22.11.2023**
(21) Application number: 22174197.8
(22) Date of filing: 18.05.2022
(51) Int. Cl.: H01S 5/183, H01S 5/026, H01S 5/02, H01S 5/062, H01S 5/06

(54) **VERTICAL LASER EMITTER AND MANUFACTURING METHOD THEREOF**

(71) Applicant: Imec VZW, 3001 Leuven (BE)
(72) Inventor: Soussan, Philippe, 1200 Wavre (BE); Caer, Charles, 1180 Uccle (BE); Rottenberg, Xavier, 3010 Kessel-lo (BE)
(74) Representative: AWA Sweden AB

(57) **Abstract**

According to an aspect of the present inventive concept there is provided a light emitting unit, for emitting laser light at a laser wavelength, arranged on a planar surface of a substrate. The unit comprises a first reflective element to reflect light at the laser wavelength, a gain element to amplify the light, and a second reflective element to partially reflect the light, and to emit the laser light. The elements form a stack of layers integrated onto the planar surface. Each layer is parallel with the planar surface, and the gain element is arranged between the first and second reflective elements.

The unit comprises a beam shaping element integrated with the stack. The beam shaping element is configured to shape the emitted laser light. The beam shaping element comprises a plurality of structures spaced apart in a direction of an extension of a layer of the beam shaping element. A size of the structures and/or a distance between adjacent structures is smaller than the laser wavelength.

## Description

### Technical field

The present inventive concept relates to the field of semiconductor laser diodes, and more specifically to a light emitting unit for emitting laser light, a light emitting device comprising an array of light emitting units and a method for manufacturing light emitting units on a substrate.

### Background

Since the creation of the first laser, the number of fields in which lasers are applied has continued to grow. Today semiconductor laser diodes are used in a vast variety of applications ranging from advanced research equipment, medical applications, and 3D sensing to data and telecommunication, and home electronics.

One type of semiconductor laser diode commonly used is the vertical cavity surface emitting laser (VCSEL), providing a laser beam which is emitted perpendicularly from the top surface. One advantage with the VCSEL technology is that it allows for the diodes to be tested throughout the production stages, enabling problems to be caught early in the production rather than at the end.

However, one problem with VCSEL diodes is that they suffer from limitations in beam quality and beam shape. The VCSEL topology and the related materials do not allow for shaping or structuring of the output laser beam. Typically, the output laser beam from a conventional VCSEL diode is a divergent beam with a divergence angle of about 20-30 degrees. However, many applications require a less divergent beam, a collimated beam or even a focused beam. Thus, external optics for collimation, focusing, or any required spatial shaping or structuring of the light need to be added to the beam path in order for the laser beam to better match the requirements of the intended application. Further, the VCSEL diodes are limited in terms of output power.

Another challenge with the VCSEL diodes is to further increase efficiency of production. The conventional manufacturing technique is restricted to small wafer sizes, onto which the individual diodes are sparsely distributed.

Thus, there is a need in the art for improved semiconductor laser diodes.

### Summary

An objective of the present inventive concept is to mitigate, alleviate or eliminate one or more of the above-identified deficiencies in the art and disadvantages singly or in any combination. These and other objectives are at least partly met by the invention as defined in the independent claims. Preferred embodiments are set out in the dependent claims.

According to a first aspect, there is provided a light emitting unit for emitting laser light at a laser wavelength, the light emitting unit being arranged on a planar surface of a substrate, wherein the light emitting unit comprises:
a first reflective element configured to reflect light at the laser wavelength;
a gain element configured to amplify the light at the laser wavelength;
a second reflective element configured to partially reflect the light at the laser wavelength, and to emit the laser light;
wherein the first reflective element, the gain element, and the second reflective element form a stack of layers integrated onto the planar surface of the substrate, wherein each layer in the stack of layers is parallel with the planar surface, and wherein the gain element is arranged between the first reflective element and the second reflective element,
wherein the light emitting unit further comprises a beam shaping element integrated with the stack of layers on the substrate, the beam shaping element being configured to shape the laser light being emitted, wherein at least a part of the beam shaping element is a separate element to the first reflective element, the gain element and the second reflective element or forms part of one or more of the first reflective element, the gain element and the second reflective element; and
wherein the beam shaping element comprises a plurality of structures spaced apart in a direction of an extension of a layer of the beam shaping element and wherein a size of the structures of the plurality of structures and/or a distance between adjacent structures is smaller than the laser wavelength.

In this context the term "light" should be allowed a wide interpretation, not limited to visible electromagnetic radiation but may also include for example ultra-violet light and infra-red light. By the "visible" part of the wavelength spectrum is here meant electromagnetic radiation within the wavelength range of 380-750 nm. By the "infrared (IR)" part of the wavelength spectrum is here meant electromagnetic radiation within the wavelength range of 750 nm to 1 mm. By the "near infrared (NIR)" part of the wavelength spectrum is here meant electromagnetic radiation within the wavelength range of 750-1000 nm. By the "short wave infrared (SWIR)" part of the wavelength spectrum is here meant electromagnetic radiation within the wavelength range of 1000-3000 nm. By way of example, the laser light emitted from the light emitting unit may have a laser wavelength from NIR to SWIR, such as from 850 nm to 1350 nm.

By the term "reflective element" is here meant any unit or element configured to reflect light at the laser wavelength. A reflective element may comprise one or more reflective layers. A reflective layer may be a uniform layer, or it may comprise a plurality of structures spaced apart in a direction of an extension of the reflective layer. A size of the structures of the plurality of structures and/or a distance between adjacent structures may be smaller than the laser wavelength. By way of example, a reflective element may be, but is not limited to, a uniform mirror, a high contrast grating (HCR), a distributed Bragg reflector (DBR), or a reflective electromagnetic metasurface. By way of example, a reflective element may be produced by epitaxial deposition. By way of further example, a reflective element may be produced by successive epitaxial deposition and advanced lithography in order to provide a plurality of structures with a size and/or distance being smaller than the laser wavelength.

By the term "smaller than the laser wavelength" is here meant any size that is not larger than or equal to the laser wavelength. Given as a non-limiting example, in case of a reflective element being a high contrast grating, the distance between adjacent structures, or rather the pitch of the structures may be slightly smaller than the laser wavelength λ in order to achieve the desired properties, such as 0.99 x λ, or 0.95 x λ. Given as another non-limiting example, in case of a reflective element being a metasurface, the lattice constant of the structure may be much smaller than the wavelength, such as 0.5 x λ or smaller. It serves to mention that by the capabilities of advanced lithography available at present, the smallest size structures that may be patterned is the size of 50 nm or 30 nm. However, as the technology of advanced lithography develops it may be possible to pattern smaller structures in the future, such as 10 nm or 5 nm. Thus, structures smaller that the laser wavelength may have a size in the range of from λ to 50 nm, or to 30 nm, however, may in the future range from λ to 10 nm or to 5 nm.

By the term "pitch" is here meant the distance from a center of a structure to the center of a consecutive structure. In other words, the pitch includes a width of a structure as well as a separation between two consecutive structures.

It should be understood that any of the elements of the light emitting unit, such as the first and second reflective elements, the gain element and/or the beam shaping element, may each be made of a single layer or may be made of a plurality of layers, respectively. It is conceivable that a reflective element may be formed of a single layer of a reflective material, or alternatively be formed of a plurality of layers. By way of example, a reflective element may be formed of a plurality of layers with alternating high and low refractive indices, wherein each layer of the plurality of layers has a thickness corresponding to a quarter of the laser wavelength.

It should be understood that the first reflective element may be provided either directly on the planar surface of the substrate, or alternatively with buffer spacer element in between the substrate and the first reflective element.

By the term "gain element" is here meant any element configured to amplify light at the laser wavelength, by means of stimulated emission, when light passes through the element. If the gain element is provided with population inversion stimulated emission may occur. Given as non-limiting examples, population inversion in the gain element may be provided by means of electrodes over which an electric field is provided such that an electric current is generated through the gain element, or by means of optical pumping wherein an external light source illuminates the gain element. By way of example, a gain element may be produced by epitaxial deposition.

The light emitting unit may be in the form of a semiconductor laser diode. The first reflective element and the second reflective element are arranged parallel to the planar surface of the substrate, and spaced apart such that the first reflective element and the second reflective element form a resonator for the laser wavelength. Thus, an optical axis of the resonator extends in a direction vertical to the planar surface of the substrate. In this respect, the light emitting unit may be considered to be a so-called vertical cavity surface emitting laser (VCSEL). The gain element is arranged between the first reflective element and the second reflective element such that, when population inversion is provided in the gain medium, the gain medium may amplify the light in the resonator.

The first reflective element is configured to reflect light at the laser wavelength. The first reflective element may function as an end mirror of the resonator. As such, the first reflective element should have a high reflectance at the laser wavelength. Given as non-limiting examples, at least 98% of the light at the laser wavelength incident onto the first reflective element should be reflected, preferably at least 99%, more preferably at least 99.5%, and most preferably at least 99.9%.

The second reflective element is configured to partially reflect the light at the laser wavelength. The second reflective element may function as an output coupler of the resonator. Given as non-limiting examples, between 50%-99% of the light at the laser wavelength incident onto the second reflective element should be reflected, such as between 60%-98%, and such as 85%-95%. The light at the laser wavelength incident onto the second reflective element and not being reflected, may at least partly be emitted through the second reflective element, thereby leaving the resonator as laser light. The laser light may be emitted in a direction substantially perpendicular to the planar surface of the substrate.

By the term "beam shaping element" is here meant any element configured to shape the beam of the laser light being emitted from the light emitting unit. Typically, a beam of laser light emitted from a conventional semiconductor laser diode is a divergent beam, which may not be suitable for all applications. Thus, the beam shaping element of the light emitting unit may for example collimate the emitted beam of laser light into a collimated laser beam being emitted from the light emitting unit. Such a collimated laser beam may be suited for some applications. Alternatively, the beam shaping element may for example focus the emitted beam of laser light into a focused laser beam having a specific focal length. Such a focused laser beam may be suited for some applications. Further, the beam shaping element may for example re-shape the cross-sectional shape of the beam of laser light into a desired shape. By way of example, the beam shaping element may re-shape an initially circular cross-section into a narrow rectangular cross-section, being suited for creating a light sheet. By way of further example, the beam shaping element may re-shape an initially oval cross-section into a circular cross-section, which may be preferrable in for example telecommunication applications.

The beam shaping element is integrated with the stack of layers on the planar surface of the substrate, such that the beam shaping element comprises at least one layer arranged in parallel with the planar surface of the substrate. It is conceivable that the beam shaping element comprises a plurality of layers. The plurality of layers may be arranged in the vicinity to each other, or at least some of the layers of the plurality of layers may alternatively be distributed in the light emitting unit at a distance to other layers of the beam shaping element.

The beam shaping element comprises a plurality of structures spaced apart in a direction of an extension of one of the layers of the beam shaping element. A size of the structures of the plurality of structures and/or a distance between adjacent structures is smaller than the laser wavelength. By way of example, the beam shaping element may be produced by successive epitaxial deposition and advanced lithography in order to provide the plurality of structures with a size and/or distance being smaller than the laser wavelength. In the present manner, a beam shaping element may be formed, comprising one or more patterned layers.

An advantage of the first aspect is that steering and shaping of the laser beam with respect to the optical axis of the resonator in the light emitting unit may be provided. The light emitting unit may thus be configured to have a desired output laser beam direction, divergence, and cross-sectional shape emitted directly from the light emitting unit. The present arrangement may eliminate the need for additional, off-chip optics arranged in the beam path after the light emitting unit, to shape the laser beam, since the desired beam shape may be provided directly on-chip by the integrated parts of the light emitting unit.

Another advantage is that, since the need for external bulky optics may be eliminated, the desired beam characteristics may be provided by a much smaller unit than would otherwise be the case when using conventional semiconductor laser diodes.

Yet another advantage is that a light emitting unit providing a laser beam with higher power may be provided. The precision and accuracy in providing manufacturing and alignment of the sub-wavelength structures and other components of the light emitting unit, facilitates a light emitting unit with a higher output power to be provided.

According to an embodiment, the second reflective element comprises a plurality of structures spaced apart in a direction of an extension of a layer of the second reflective element and wherein a size of the structures of the plurality of structures and/or a distance between adjacent structures is smaller than the laser wavelength.

By way of example, the second reflective element may be produced by successive epitaxial deposition and advanced lithography in order to achieve the plurality of structures with a size and/or distance to be smaller than the laser wavelength.

An advantage with this embodiment is that the plurality of structures of the beam shaping element and the plurality of structures of the second reflective element jointly provide the effect of shaping the emitted laser beam. The present arrangement may be more flexible in how the beam may be shaped. Further, it may provide an even more compact light emitting unit.

According to an embodiment, the gain element comprises a plurality of structures spaced apart in a direction of an extension of a layer of the gain element and wherein a size of the structures of the plurality of structures and/or a distance between adjacent structures is smaller than the laser wavelength.

Given as a non-limiting example, the gain element may comprise said plurality of structures being sub-wavelength structures, so as to form at least a part of the beam shaping element as part of the gain element. Given as another non-limiting example, the gain element may comprise said plurality of structures being sub-wavelength structures, so as to form a photonic crystal. By such a photonic crystal, the output power of the light emitting unit may be increased by several orders of magnitude.

According to an embodiment, the light emitting unit further comprises a first spacer element arranged between the gain element and the second reflective element, the first spacer element being configured to provide a desired distance between the first reflective element and the second reflective element.

By selecting a thickness and a refractive index of the first spacer element, the distance, or rather the optical path length, between the first reflective element and the second reflective element may be selected so as to create a resonator for the laser wavelength intended for the emitted laser light. For example, the optical path length between the first reflective element and the second reflective element may be selected to be a multiple of the laser wavelength. In other words, the laser wavelength of the emitted laser light may be controlled by selecting of the thickness and the refractive index of the first spacer element.

Another function of the first spacer element is to provide a sufficiently large refractive index contrast between the second reflective element and the layers below. By the layers "below" is here meant the layers arranged on the opposite side of the first spacer element as compared to the second reflective element.

Further, in the case of the beam shaping element being arranged at least partly within the resonator, the first spacer element may also be arranged so as to isolate the beam shaping element from the gain element.

An advantage with the embodiment is that the large refractive index contrast provided by the spacer element may enable a large reflectivity of the second reflective element.

According to an embodiment, the beam shaping element is a separate element and wherein the beam shaping element and the gain element are arranged on opposite sides of the second reflective element.

In other words, the beam shaping element may be arranged outside the resonator, such that the laser beam emitted through the second reflective element is subsequently passed through the beam shaping element prior to being emitted from the light emitting unit. Given as non-limiting examples, the beam shaping element may be in the form of a micro lens, a Fresnel phase plate, a photonic crystal, or any other suitable element for shaping the emitted laser beam.

According to an embodiment, the light emitting unit further comprises a second spacer element arranged between the second reflective element and the beam shaping element, the second spacer element being configured to provide a desired distance therebetween.

In the case of the beam shaping element being arranged outside the resonator, the second spacer element may provide a distance, or rather an optical path length, between the second reflective element and the beam shaping element such that the intended beam shaping may be provided. The beam shaping effect may be varied by varying the thickness and/or the refractive index of the second spacer element. By way of example, if the laser beam emitted through the second reflective element is a divergent laser beam, the cross-section of the laser beam will be larger the larger the distance from the second reflective element. In the present example, if a collimated laser beam with a predetermined diameter is to be provided as an output laser beam from the light emitting unit, a specific distance between the second reflective element and the beam shaping element may be required, wherein the beam shaping element is a beam collimating element. Thus, the effect of beam shaping, e.g. beam collimation in the present example, is provided by the combination of the second spacer element and the beam shaping element.

An advantage with this embodiment is that manufacturing of the light emitting unit may be more flexible. Light emitting units with a wider range of beam properties may be provided, since different light emitting units with different beam properties may be manufactured by means of essentially the same type of elements by only varying the thickness and/or refractive index of the second spacer element.

According to an embodiment, the at least part of the beam shaping element is arranged within one of the first reflective element and the second reflective element.

According to an embodiment, the at least part of the beam shaping element is arranged between the second reflective element and the gain element.

The beam shaping element may be formed of a single layer, or alternatively may be formed of a plurality of layers. Thus, it is conceivable that the beam shaping element may not necessarily be a single, separate element, but rather may comprise different parts, such as layers, distributed throughout the light emitting unit. For example, the beam shaping element may comprise layers, some of which are distributed in the gain element and some of which are distributed in one of the reflective elements or in both reflective elements. Given as a non-limiting example, the gain element may comprise a plurality of structures spaced apart in a direction of an extension of a layer of the gain element and wherein a size of the structures of the plurality of structures and/or a distance between adjacent structures is smaller than the laser wavelength, forming one-dimensional gratings or two-dimensional photonic crystals of holes and/or pillars, as part of the beam shaping element.

According to an embodiment, the light emitting unit further comprises a tunable element integrated with the stack of layers on the substrate, the tunable element being configured to provide tunability to the laser light.

The tunable element may comprise an electro-optic layer comprising an electro-optic material. The electro-optic material may be transparent to the laser wavelength. The electro-optic material comprises an electro-optic property such that when an electric field is applied to the electro-optic layer, a refractive index of the electro-optic layer may change. Consequently, the optical path length for light propagating through the electro-optic layer may also change. Thus, by varying the electric field applied to the electro-optic layer, properties of the electro-optic element may be tunable. By way of example, the tunable element may provide tuning of wavelength, polarization, phase, intensity, and/or direction and thereby also collimation and illumination pattern of the laser light.

An advantage with this embodiment is that a light emitting unit with tunable output directly from the diode may be provided. Properties of tunable light, as for example wavelength, polarization, phase, intensity, direction, and/or collimation is required in many applications. By providing tunability on the light emitting unit directly may eliminate the need for bulky external tuning devices. In the present manner, a more compact light source with tuning capability may be provided.

According to an embodiment, the tunable element comprises a BaTiO₃ based electro-optic layer.

According to an embodiment, the tunable element is arranged within one of the first reflective element, the gain element, and the second reflective element.

According to an embodiment, the substrate comprises Germanium.

The substrate should be of a material onto which the materials of the stack of layers may be grown. More specifically, in order to enable integration of the layers onto the planar surface of the substrate, the lattice structures of the substrate and the layers need to be closely matched. By way of example, in order to ensure a good match materials should be selected having lattice constants differing with 0.04 nm or less with respect to each other. Further, in order for the structure to be able to handle temperature variations, materials with similar coefficients of thermal expansion (CTE) need to be selected. By way of example, in order to ensure a good CTE match materials should be selected having CTE not differing by more than 5% with respect to each other. In view of the above, if a gain element of GaAs is to be used, a substrate of e.g. GaAs or Ge may be selected, since the materials have similar properties.

In manufacturing of conventional VCSEL diodes typically GaAs is used as a substrate. These are manufactured in facilities not being equipped for using advanced lithography, such as 193 nm UV lithography. In such approach, there is thus limitations in what structures can be made.

An advantage with the embodiment of a Germanium substrate is that the light emitting unit may be formed on a material which may also be advantageously used as a substrate for forming semiconductor devices. In factories for manufacturing semiconductor devices, equipment for using high-precision lithography is normally present. Thus, where the light emitting unit is formed on a Germanium substrate, semiconductor factories for manufacturing of semiconductor devices on Germanium may be utilized to provide access to equipment for high-precision lithography for manufacturing of the light emitting unit.

According to an embodiment, the light emitting unit further comprises a first electrode and a second electrode integrated with the stack of layers on the substrate, wherein the first electrode and the second electrode are arranged on opposite sides of the gain element in the stack of layers, and wherein the first electrode and the second electrode are configured to generate a population inversion in the gain element.

The first electrode and the second electrode may be arranged as separate layers in the stack of layers, extending in a direction parallel to the planar surface of the substrate. The first electrode and the second electrode may have low resistance to provide Ohmic contact, for example lower than 10⁻⁵ Ω·cm², and preferably lower than 10⁻⁶ Ω·cm². The first electrode and/or the second electrode may respectively comprise an array of microelectrodes. Each microelectrode in the array of microelectrodes may be in the form of plugs, such as having a cylindrical shape. Each plug may be made of metal. The plugs or microelectrodes may be distributed across a layer of the first electrode and the second electrode, respectively.

It should be understood that the first electrode and/or the second electrode may be made of a material being transparent to the laser wavelength. For example, if the second electrode is arranged between the second reflective element and the gain element, and thus inside the resonator, light in the resonator needs to be able to pass through the second electrode. This may be provided by a second electrode made of a material transparent to the laser wavelength. An electrode arranged outside the resonator may be made of a material transparent to the laser wavelength, or it may be made of a material that is not transparent to the laser wavelength.

By the present arrangement, population inversion in the gain element may be provided by means of the first electrode and the second electrode over which an electric field may be provided such that an electric current may be generated through the gain medium. The electric current may excite an active medium in the gain element such that population inversion is provided.

An advantage with this embodiment is that it is a simple manner to provide population inversion without the use of an external light source for optically pumping the gain element.

Another advantage is that the output power of the emitted laser light may be easily controllable by controlling the voltage of the applied electric field. By the present arrangement, a light emitting unit with an easily controllable output power may be provided.

According to an embodiment, the light emitting unit further comprises a first contact and a second contact, the first contact and the second contact extending through at least some of the layers in the stack, and being connected to the first electrode and the second electrode, respectively, the first contact and the second contact enable electric control of the light emitting unit, and wherein at least one of the first contact and the second contact has a cross-sectional width of less than 1 µm.

As previously mentioned, the first electrode and the second electrode may be arranged as separate layers in the stack of layers, extending in a direction parallel to the planar surface of the substrate. The first contact and the second contact, on the other hand, may be configured to respectively have a small cross-section in the direction parallel to the planar surface of the substrate. Given as a non-limiting example, a width of the cross-section of the first and/or second contact may be 1 µm or less. Further, the first contact and the second contact may be arranged to extend from the first electrode and the second electrode, respectively, and to extend through at least some of the layers arranged above the respective electrode. By the layers "above" the electrode is here meant the layers arranged on the opposite side of the electrode as compared to the substrate. By the present arrangement, the first contact and the second contact may provide connections to the first and second electrodes from the layers above the respective electrodes, thereby providing means for control of the laser.

It is conceivable the first electrode and the second electrode are not connected to only one first contact and one second contact, respectively. As an alternative, the first electrode may be connected to a plurality of first contacts, and/or the second electrode may be connected to a plurality of second contacts.

An advantage with a plurality of first and second contacts is that it may facilitate a higher electric current to be provided to the gain element, thereby increasing the output power of the light emitting unit. As the cross-section of the first and second contacts may be very small compared to the surface of the layers in the stack of layers, the maximum current that can be provided by single contacts may be limited. Such limitation is overcome by the use of a plurality of first and second contacts.

According to an embodiment, the first reflective element, the gain element, and the second reflective element respectively, are arranged along an optical axis such that a center of the first reflective element, the gain element, and the second reflective element respectively, does not deviate from the optical axis by more than 100 nm, and wherein the optical axis extends in a direction perpendicular to the planar surface of the substrate.

Preferably, the first reflective element, the gain element, and the second reflective element respectively, are arranged such that the center of the first reflective element, the gain element, and the second reflective element respectively, does not deviate from the optical axis by more than 30 nm.

It should be understood that, although it has been referred to the optical axis of the resonator, the optical axis is not restricted to extend only inside the resonator, but rather the optical axis may extend also external to the resonator.

Further, the beam shaping element may be arranged along the optical axis such that a center of the beam shaping element does not deviate from the optical axis by more than 100 nm, and preferably by not more than 30 nm.

Further, the second electrode may be arranged along the optical axis such that a center of the second electrode does not deviate from the optical axis by more than 100 nm, and preferably by not more than 30 nm.

It should be understood that especially for elements comprising structures with a size or a distance smaller than the laser wavelength, it is important that the structures may be positioned with a high accuracy and precision. Positioning of the structures within an element may affect an overall optical effect of the element. Thus, positioning of the structures with high accuracy and precision may be important for aligning the elements comprising small structures with the optical axis.

An advantage with this embodiment is that the different elements of the light emitting unit are positioned with a very high precision. By positioning the elements of the light emitting unit with high precision, a light emitting unit with a good laser beam quality and a high output laser power may be provided.

According to a second aspect of the present inventive concept there is provided a light emitting device comprising:
a substrate comprising a planar surface;
an array of light emitting units according to the first aspect, the array of light emitting units being arranged on the planar surface of the substrate.

According to an embodiment, the array of light emitting units has a pitch of light emitting units of less than 1000 µm, preferably less than 100 µm, and most preferably less than 60 µm.

An advantage with this embodiment is that a large number of light emitting units may be provided on the same substrate. Moreover, with a pitch of light emitting units being low, light emitting units may be provided with a high density on the substrate.

Another advantage is that the large number of light emitting units on the substrate, especially at high density, allows for cost efficient production such that the price per light emitting unit may be low.

According to a third aspect of the present inventive concept there is provided a method for manufacturing a light emitting unit on a substrate comprising a planar surface, the light emitting unit being configured for emitting laser light at a laser wavelength, the method comprising:
forming a light emitting unit arranged on the planar surface of the substrate, wherein the forming of the light emitting unit comprises:
   forming a first reflective element;
   forming a gain element by epitaxial deposition on the first reflective element;
   forming a second reflective element;
wherein the first reflective element, the gain region, and the second reflective element form a stack of layers integrated onto the planar surface of the substrate, wherein each layer in the stack of layers is parallel with the planar surface, and wherein the gain element is formed to be arranged between the first reflective element and the second reflective element,
wherein the forming of the light emitting unit further comprises:
   forming a beam shaping element integrated with the stack of layers on the substrate, the beam shaping element being configured to shape the laser light being emitted, wherein the beam shaping element is a separate element to the first reflective element, the gain element and the second element or forms part of one or more of the first reflective element, the gain element and the second element;
wherein the forming of the beam shaping element involves lithography for forming a plurality of structures spaced apart in a direction of an extension of a layer of the beam shaping element such that a size of the structures of the plurality of structures and/or a distance between adjacent structures is smaller than the laser wavelength.

An advantage is that a method of manufacturing of light emitting units within which steering and shaping of the laser beam with respect to the optical axis of the resonator in the light emitting unit may be provided. The light emitting unit may thus be manufactured to have a desired output laser beam direction, divergence, and cross-sectional shape emitted directly from the light emitting unit. The method of manufacturing may thus provide light emitting units for which the need for additional, off-chip optics in the beam path after the light emitting unit may be eliminated. Consequently, the method of manufacturing may provide light emitting units with desired beam characteristics yet with a much smaller unit size than would otherwise be the case when using conversional semiconductor laser diodes combined with external optics.

According to an embodiment, the forming of the second reflective element involves lithography to form a plurality of structures, wherein a size of the structures of the plurality of structures and/or a distance between adjacent structures is smaller than the laser wavelength.

According to an embodiment, the method further comprises forming a first spacer element arranged between the gain element and the second reflective element, such that a desired distance is provided between the first reflective element and the second reflective element.

According to an embodiment, the forming the beam shaping element comprises arranging the beam shaping element on an opposite side of the second reflective element with respect to the gain element.

According to an embodiment, the forming of the light emitting unit comprises arranging the first reflective element, the gain element, and the second reflective element respectively, along an optical axis such that a center of the first reflective element, the gain element, and the second reflective element respectively, does not deviate from the optical axis by more than 100 nm, and wherein the optical axis extends in a direction perpendicular to the planar surface of the substrate.

Preferably, the forming of the light emitting unit comprises arranging the first reflective element, the gain element, and the second reflective element respectively, such that the center of the first reflective element, the gain element, and the second reflective element respectively, does not deviate from the optical axis by more than 30 nm.

Further, the forming of the light emitting unit comprises arranging the beam shaping element along the optical axis such that a center of the beam shaping element does not deviate from the optical axis by more than 100 nm, and preferably by not more than 30 nm.

An advantage with this embodiment is that the high precision and accuracy by the method of manufacturing in positioning and aligning the sub-wavelength structures and other components of the light emitting unit, facilitates a higher power laser diode to be provided.

Another advantage is that the method for manufacturing a light emitting unit may provide a cost-efficient production of light emitting units, such that the price per light emitting unit may be low. By way of example, the method may allow for a large number of light emitting units to be provided on the same substrate. The high precision in advanced lithography in positioning the elements or parts of element may further allow for the light emitting units to be provided on the substrate such that the pitch of light emitting units may be low, whereby light emitting units may be provided on the substrate with a high density.

According to an embodiment, substrate is a wafer having a width of at least 200 mm.

An advantage with this embodiment is that by using a relatively large wafer as the substrate, an array of light emitting units comprising a large number of light emitting units may be efficiently manufactured. The present approach may provide cost effective as well as time effective manufacturing of light emitting units.

Effects and features of the second and third aspects are largely analogous to those described above in connection with the first aspect. Embodiments mentioned in relation to the first aspect are largely compatible with the second and third aspects. It is further noted that the inventive concepts relate to all possible combinations of features unless explicitly stated otherwise.

Other objectives, features and advantages of the present inventive concept will appear from the following detailed disclosure, from the attached claims as well as from the drawings.

### Brief descriptions of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1A illustrates a light emitting unit with the reflective elements being uniform mirrors.
Fig. 1B illustrates a light emitting unit with one of the reflective elements comprising a patterned structure.
Fig. 2A illustrates a light emitting unit comprising a first spacer element arranged between the gain element and the second reflective element.
Fig. 2B illustrates a light emitting unit comprising a second spacer element arranged between the second reflective element and the beam shaping element.
Fig. 2C illustrates a light emitting unit comprising a buffer spacer element arranged between the substrate and the first electrode.
Fig. 3 illustrates a light emitting unit comprising a tunable element integrated with the stack of layers on the substrate.
Fig. 4 illustrates a light emitting device comprising an array of light emitting units being arranged on the planar surface of the substrate.
Fig. 5 illustrates a schematic block diagram summarizing a method for manufacturing a light emitting unit on a substrate comprising a planar surface, the light emitting unit being configured for emitting laser light at a laser wavelength.

### Detailed description

In cooperation with attached drawings, the technical contents and detailed description of the present inventive concept are described thereinafter according to a preferable embodiment, being not used to limit the claimed scope. This inventive concept may be embodied in many different forms and should not be construed as limited to the embodiments set forth herein; rather, these embodiments are provided for thoroughness and completeness, and fully convey the scope of the inventive concept to the skilled person.

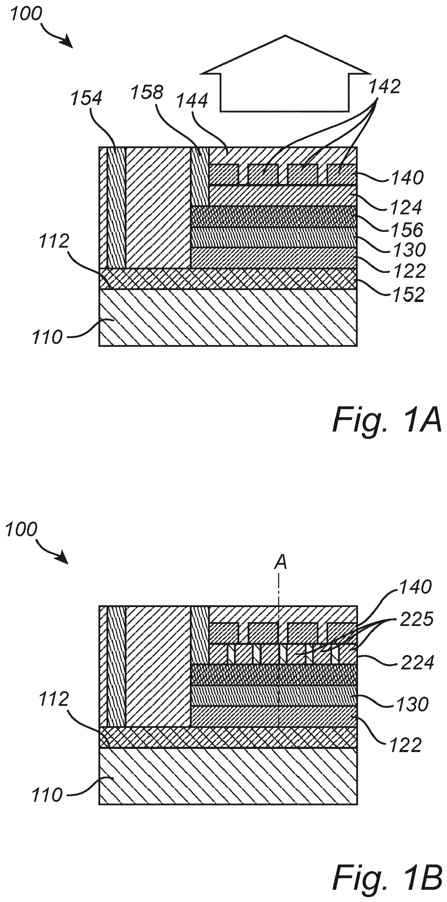

Fig. 1A schematically illustrates a light emitting unit 100. The light emitting unit 100 comprises a stack of layers arranged on a planar surface 112 of a substrate 110. The substrate 110 comprises Germanium, however it should be understood that also other materials may be used for the substrate 110, as for example GaAs, Si, SiC, AIN, or Sapphire. The light emitting unit 100 is a semiconductor laser diode, and as such the light emitting unit 100 is configured for emitting laser light at a laser wavelength.

The laser beam emitted from the light emitting unit 100 is emitted in a vertically upward direction substantially perpendicular to the planar surface 112 of the substrate 110. It should be understood that even if the laser beam were not perfectly collimated, as for example if the laser beam were a divergent laser beam such that some rays of laser light may have a direction not being perpendicular to the planar surface 112 of the substrate 110, the average direction of all the rays of laser light emitted from the light emitting unit 100 may be perpendicular to the planar surface 112 of the substrate 110. In such a case the main direction of the emitted laser beam is still considered to be perpendicular to the planar surface 112 of the substrate 110, despite some individual rays having a different direction.

The light emitting unit 100 comprises a first reflective element 122 and a second reflective element 124. The first reflective element 122 and the second reflective element 124 form layers in the stack of layers which are arranged parallel to the planar surface 112 of the substrate 110, and spaced apart so as to form a resonator for the laser light. The first reflective element 122 is configured to reflect substantially all light at the laser wavelength incident onto the first reflective element 122, so that the first reflective element 122 functions as an end mirror of the resonator. The second reflective element 124 is configured to partially reflect the light at the laser wavelength. At least some of the light incident onto the second reflective element 124, and not being reflected by the second reflective element 124 may be emitted through the second reflective element 124 as laser light. The second reflective element 124 thus functions as the output coupler of the resonator.

Between the first and second reflective elements 122,124 a gain element 130 is arranged. The gain element 130 is configured to amplify light at the laser wavelength by stimulated emission of radiation. Amplification by stimulated emission of radiation may occur if the gain element 130 is provided with population inversion. This may be provided in a number of different ways, however in the present embodiment of the light emitting unit 100, population inversion is provided by generation of an electric current in through the gain element 130. For this purpose, a first electrode 152 and a second electrode 156 are arranged on opposite sides of the gain element 130 in the stack of layers. In the present arrangement, the first electrode 152 is arranged outside the resonator, between the substrate 110 and the first reflective element 122. However, it should be realized that the first electrode 152 may alternatively be arranged inside the resonator, between the first reflective element 122 and the gain element 130. The second electrode 156 is arranged inside the resonator between the gain element 130 and the second reflective element 124. In order to enable electric control of the light emitting unit, the first electrode 152 is connected to a first contact 154, and the second electrode 156 is connected to a second contact 158. As illustrated in Fig. 1A, the first contact 154 and the second contact 158 extend in a direction substantially perpendicular to planar surface 112 of the substrate 110, through some of the layers in the stack, located above the respective electrodes 152, 154. In other words, the contacts 154, 158 extend in the vertical direction of the light emitting unit 100, whereas the planar surface 112 of the substrate 110 extends in the horizontal direction of the light emitting unit 100. The contacts provide access to apply an electric field between the electrodes 152, 154. The applied electric field may generate an electric current through the gain element 130, which may in turn provide population inversion in the gain element 130.

At least one of the first contact 154 and the second contact 158 has, and in the present arrangement both contacts 154, 158 have a cross-sectional width of less than 1 µm. By way of example, such small cross-sectional width may be achieved first providing all the layers in the stack of layers on the substrate, for example by epitaxial deposition, and subsequently applying advanced lithography in order to enable etching holes through the layers such that the holes reach down to the first electrode 152 and second electrode 156, respectively. After the holes have been etched to reach the electrodes, the holes may be filled with a metal to form the first contact 154 and the second contact 158, thereby providing electric connections to the electrodes 152, 156 from outside the light emitting unit 100.

The light emitting unit 100 further comprises a beam shaping element 140 integrated with the stack of layers on the substrate 110. In the present arrangement, the beam shaping element 140 is a separate element to the first reflective element 122, the gain element 130 and the second reflective element 124. The beam shaping element 140 is arranged external to the resonator such that the laser beam emitted through the second reflective element 124 subsequently propagates through the beam shaping element 140 prior to being emitted from the light emitting unit 100. In other words, the beam shaping element 140 and the gain element 130 are arranged on opposite sides of the second reflective element 124. However, it should be understood that the beam shaping element 140 may alternatively form part of one or more of the first reflective element 122, the gain element 130 and the second reflective element 124.

The beam shaping element 140 comprises a plurality of structures 142 spaced apart in a direction of an extension of a layer of the beam shaping element 140. In other words, the plurality of structures 142 are spaced apart and distributed across a plane parallel to the planar surface 112 of the substrate 110. The size of the structures 142 of the plurality of structures 142 and/or a distance between adjacent structures 142 is smaller than the laser wavelength. The beam shaping element 140 may be produced by successive epitaxial deposition and advanced lithography in order to provide the plurality of structures 142 with a size and/or distance being smaller than the laser wavelength. By epitaxial deposition a layer of a reflective material is provided and by use of advanced lithography structures 142 are formed by etching spaces in the layer, leaving the segments of the material forming the plurality of structures 142. By way of example, the reflective material may be, but is not limited to, GaAs or AIGaAs. Once the etching of the structures is completed the spaces may be filled with a dielectric material. Given as non-limiting examples, the dielectric material may be SiO₂, with a refractive index of about 1.45, or other oxides such as TiO₂. Other non-limiting examples of dielectric materials are SiN and polymers. The refractive index of the selected dielectric material may preferably be 1.5 or below. In this manner, a compact beam shaping element 140 integrated in the light emitting unit 100 may be provided. Given as non-limiting examples, the beam shaping element 140 may be in the form of a micro lens, a Fresnel phase plate, a photonic crystal, or any other suitable element for shaping the emitted laser beam.

The beam shaping element 140 is configured to shape the laser light being emitted by the light emitting unit 100. In the present embodiment, the beam shaping element 140 collimates the emitted divergent beam of laser light into a collimated laser beam being emitted from the light emitting unit 100. However, it should be understood that the beam shaping element 140 may alternatively be configured to re-shape the emitted laser beam in other manners, such as to focus the emitted beam of laser light into a focused laser beam, or to re-shape the cross-sectional shape of the beam of laser light into a desired shape.

Fig. 1B schematically illustrates an alternative variation of the light emitting unit 100. For the light emitting unit 100 in relation to Fig. 1A, the first and second reflective elements are illustrated as uniform mirrors. However, it should be understood that the first and/or second reflective element may alternatively comprise a patterned structure. Fig. 1B illustrates an alternative variation of the light emitting unit 100, in which the second reflective element 224 is illustrated as comprising a patterned structure. Thus, the second reflective element 224 comprises a plurality of structures 225 spaced apart in a direction of an extension of a layer of the second reflective element 224. In other words, the plurality of structures 225 are spaced apart and distributed across a plane parallel to the planar surface 112 of the substrate 110. The size of the structures 225 of the plurality of structures 225 and/or a distance between adjacent structures 225 is smaller than the laser wavelength.

Similarly to the beam shaping element 140, the second reflective element 224 may be produced by successive epitaxial deposition and subsequent etching using advanced lithography in order to provide the plurality of structures 225 with a size and/or distance being smaller than the laser wavelength. Once the etching is completed the spaces between the plurality of structures 225 may be filled with a dielectric material.

It serves to mention that by successive epitaxial deposition and subsequent etching using advanced lithography, the elements, and the structures of the elements, may be arranged with a very high precision and accuracy. For example, the elements may be aligned with high precision and accuracy with respect to an optical axis. The optical axis A of the light emitting unit 100 extends through the center of the resonator, in a direction perpendicular to the planar surface 112 of the substrate 110. The elements such as the first reflective element 122, the gain element 130, and the second reflective element 224 may respectively be arranged along the optical axis A such that the center of the respective elements does not deviate from the optical axis A by more than 100 nm. Preferably, the center of the respective elements does not deviate from the optical axis A by more than 30 nm.

In the present variation of the light emitting unit 100, the patterned structure of the beam shaping element 140 and the patterned structure of the second reflective element 224 jointly provide the effect of shaping the emitted laser beam, as for example collimating the emitted laser beam. In the present arrangement, it may be considered that at least part of the beam shaping element 140 forms part of the second reflective element 224.

Although not illustrated here, it is conceivable that additionally or alternatively the gain element and/or the first reflective element may be patterned to comprise a plurality of structures, so as to form part of the beam shaping element. It is further conceivable that at least part of the beam shaping element may be arranged between the second reflective element and the gain element.

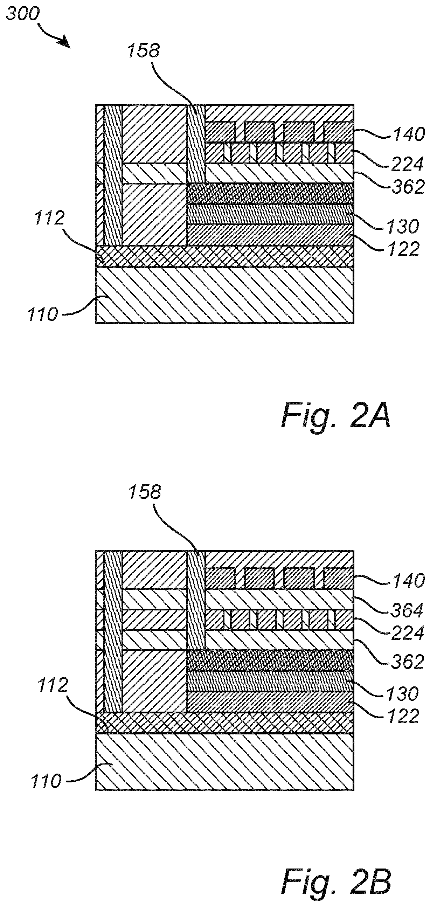

Figs 2A-C schematically illustrates a light emitting unit 300 comprising one or more spacer elements. The light emitting unit 300 comprises a stack of layers comprising a first reflective element 122, a gain element 130, a second reflective element 224, and a beam shaping element 140, arranged onto a planar surface 112 of a substrate 110, and shares some of the features with light emitting unit 100 described in relation to Fig. 1, the details of which are not repeated here.

Fig. 2A schematically illustrates the light emitting unit 300 further comprising a first spacer element 362 arranged between the gain element 130 and the second reflective element 224. The first spacer element 362 is configured to provide a desired distance between the first reflective element 112 and the second reflective element 224.

The combination of the thickness and the refractive index of the first spacer element 362 provides an additional distance, or rather optical path length, between the first reflective element 122 and the second reflective element 224. In this manner, the optical path length for light of the laser wavelength may be selected so as to create a resonator for the laser wavelength, thereby controlling the laser wavelength of the emitted laser light.

It should be understood that in case at least part of the beam shaping 140 forms part of other elements in the light emitting unit 300, the first spacer element 362 may have the additional effect of contributing to the beam shaping properties of the light emitting unit 300 as a whole, since the optical path length of the resonator may affect properties of the propagating light beam.

Fig. 2B schematically illustrates the light emitting unit 300 further comprising a second spacer element 364 arranged between the second reflective element 224 and the beam shaping element 140. The second spacer element 364 is configured to provide a desired distance, or rather an optical path length, between the second reflective element 224 and the beam shaping element 140, in order to provide the intended beam shaping.

By varying the thickness and/or the refractive index of the second spacer element, the beam shaping effect may be varied. For example, a divergent laser beam being emitted through the second reflective element 224 will have a different beam diameter depending on the distance from the second reflective element 224. Thus, to provide a collimated laser beam with a predetermined diameter the beam shaping element 140 should be arranged at a predetermined distance, or optical path length, from the second reflective element 224. Hence, the effect of beam shaping, is a combination of the effect of the second spacer element 364 and the other elements in the stack.

In Figs 2A-C, the first spacer element 362 and the second spacer element 364 are illustrated as extending across the entire width of the light emitting unit 300. However, it should be understood that this is not necessary for practicing the invention. It is equally conceivable that the first spacer element 362 and the second spacer element 364 extend only to the outermost edge of the second contact 158, in the same manner as for example the first reflective element 122 and the gain element 130.

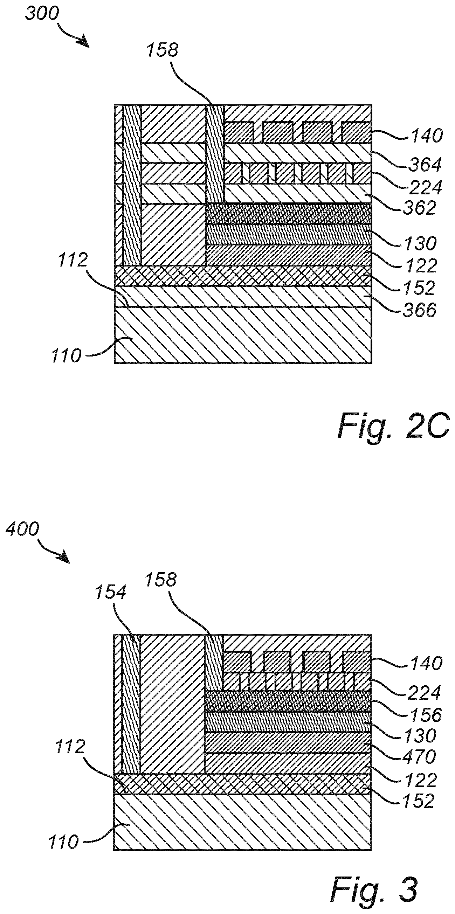

Fig. 2C schematically illustrates the light emitting unit 300 further comprising a buffer spacer element 366 arranged between the substrate 110 and the first electrode 152. The buffer spacer element 152 is made of a material providing a better fit between the lattice structure of the substrate 110 and the layers in the stack, such as the first reflective element 122, the gain element 130, and/or the first electrode 152. By way of example, the material out of which the buffer spacer is made may be, but is not limited to, SiO₂.

It should be understood that, although the buffer spacer element 152 is here illustrated only in a light emitting unit 300 comprising also a first spacer element 362 and a second spacer element 364, it is conceivable that an alternative light emitting unit 300 may comprise a buffer spacer element 152 without any of the first spacer element 362 and the second spacer element 364 being included, or only one of the first spacer element 362 and the second spacer element 364 being included.

Fig. 3 schematically illustrates a light emitting unit 400 comprising a tunable element 470. The light emitting unit 400 comprises a stack of layers comprising a first reflective element 122, a gain element 130, a second reflective element 224, and a beam shaping element 140, arranged onto a planar surface 112 of a substrate 110, and shares some of the features with light emitting units 100 and 300, described in relation to Figs 1-2, the details of which are not repeated here.

As illustrated in Fig. 3, the tunable element 470 is integrated with the stack of layers on the substrate 110, and arranged as a separate element between the first reflective element 122 and the gain element 130. However, it should be understood that the tunable element 470 may alternatively be arranged within one of the first reflective element 122, the gain element 130, and the second reflective element 124.

In order to provide tunability to the laser light of the light emitting unit 400, a BaTiO₃ based electro-optic layer is comprised in the tunable element 470. The electro-optic layer is transparent to the laser wavelength. The electro-optic properties of the electro-optic layer enables the refractive index of the electro-optic layer to be changed by varying an electric field applied across the electro-optic layer. By way of example, an electric field may be applied across the electro-optic layer of the tunable element 470 either by means of the first and second electrodes 152, 156 and the first and second contacts 154, 158, or by a set of separate electrodes and contacts (not shown here), or a combination thereof. By the present arrangement, tunability of wavelength, polarization, phase, intensity, and/or direction and thereby also collimation and illumination pattern of the laser light may be provided.

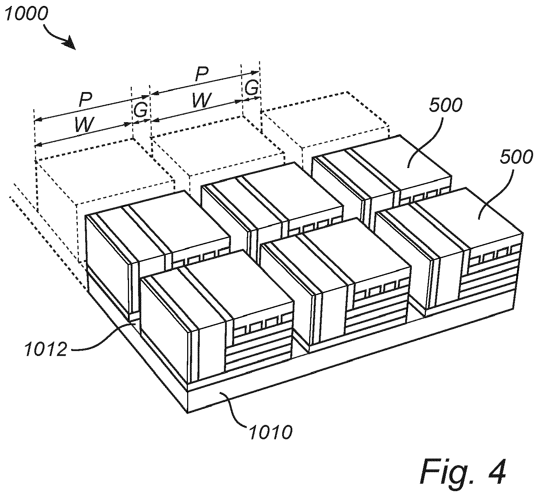

Fig. 4 schematically illustrates a light emitting device 1000 comprising an array of light emitting units 500 being arranged on a planar surface 1012 of a substrate 1010. It should be understood that the light emitting unit 500 may be any of the previously described light emitting units 100, 300, 400, or any other light emitting unit comprising a combination of the features described herein.

The substrate 1010 is a Germanium wafer. The substrate 1010 has a large width of 200 mm. The large width allows for a large number of light emitting units 500 to be arranged onto the substrate 1010. As previously described, by successive epitaxial deposition and subsequent etching by advanced lithography the structures of the different elements of the light emitting units 500 may be provided with a very high precision and accuracy. The structures may be provided to have sizes and/or distances being smaller than the laser wavelength.

Further, by successive epitaxial deposition and subsequent etching by advanced lithography the light emitting units 500 may be arranged close to each other. This is partially an effect of the high precision and accuracy of alignment of the elements. Put differently, the array of light emitting units 500 may be provided to have a pitch P of light emitting units 500 of less than 1000 µm, preferably less than 100 µm, and most preferably less than 60 µm. The pitch P of light emitting units 500 may be as low as 10 µm.

By conventional manufacturing of VCSEL diodes, the individual diodes may have a width of about 10 µm, however the pitch may be significantly larger, as for example 100 µm. This leaves gaps on the substrate between the individual diodes that are much larger than the diodes themselves. Consequently, the surface of the substrate is not efficiently used. However, by means of the present inventive concept, the light emitting units 500 may be arranged much more closely such that the gaps G between the individual light emitting units 500 may be smaller than the width W of the individual light emitting units 500. Put differently, the pitch P of light emitting units 500 may be close to the width W of individual light emitting units 500. Thus, in the present manner, the planar surface 1012 of the substrate 1010 may be much more efficiently used, and the production cost per unit may be decreased.

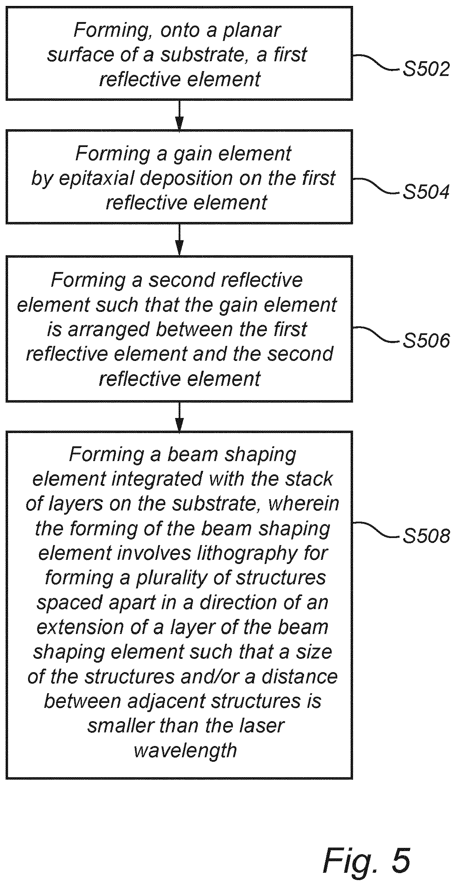

Fig. 5 illustrates a schematic block diagram shortly summarizing the method for manufacturing a light emitting unit on a substrate comprising a planar surface, the light emitting unit being configured for emitting laser light at a laser wavelength. It should be understood that the steps of the method, although listed in a specific order herein, may be performed in any order suitable.

The method may comprise forming S502 a first reflective element.

The method may comprise forming S504 a gain element by epitaxial deposition on the first reflective element.

The method may comprise forming S506 a second reflective element such that the gain element is arranged between the first reflective element and the second reflective element. The first reflective element, the gain region, and the second reflective element may form a stack of layers integrated onto the planar surface of the substrate, such that each layer in the stack of layers is parallel with the planar surface. The forming S506 the second reflective element may further involve lithography to form a plurality of structures, wherein a size of the structures of the plurality of structures and/or a distance between adjacent structures is smaller than the laser wavelength.

The method may comprise forming S508 a beam shaping element integrated with the stack of layers on the substrate. The forming S508 a beam shaping element may involve lithography for forming a plurality of structures spaced apart in a direction of an extension of a layer of the beam shaping element such that a size of the structures of the plurality of structures and/or a distance between adjacent structures is smaller than the laser wavelength. In the present manner, a beam shaping element being configured to shape the laser light being emitted by the light emitting unit may be provided. The forming S508 the beam shaping element may further comprise arranging the beam shaping element on an opposite side of the second reflective element with respect to the gain element.

The method may further comprises forming a first spacer element arranged between the gain element and the second reflective element, such that a desired distance is provided between the first reflective element and the second reflective element.

The method may further comprise arranging the first reflective element, the gain element, and the second reflective element respectively, along an optical axis such that a center of the first reflective element, the gain element, and the second reflective element respectively, does not deviate from the optical axis by more than 100 nm, and wherein the optical axis extends in a direction perpendicular to the planar surface of the substrate.

The method may comprise further comprise forming a light emitting unit on a substrate wherein the substrate is a wafer having a width of at least 200 mm.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A light emitting unit for emitting laser light at a laser wavelength, the light emitting unit being arranged on a planar surface of a substrate, wherein the light emitting unit comprises:
a first reflective element configured to reflect light at the laser wavelength;
a gain element configured to amplify the light at the laser wavelength;
a second reflective element configured to partially reflect the light at the laser wavelength, and to emit the laser light;
wherein the first reflective element, the gain element, and the second reflective element form a stack of layers integrated onto the planar surface of the substrate, wherein each layer in the stack of layers is parallel with the planar surface, and wherein the gain element is arranged between the first reflective element and the second reflective element,
wherein the light emitting unit further comprises a beam shaping element integrated with the stack of layers on the substrate, the beam shaping element being configured to shape the laser light being emitted, wherein at least a part of the beam shaping element is a separate element to the first reflective element, the gain element and the second reflective element or forms part of one or more of the first reflective element, the gain element and the second reflective element; and
wherein the beam shaping element comprises a plurality of structures spaced apart in a direction of an extension of a layer of the beam shaping element and wherein a size of the structures of the plurality of structures and/or a distance between adjacent structures is smaller than the laser wavelength.

2. The light emitting unit according to claim 1, wherein the second reflective element comprises a plurality of structures spaced apart in a direction of an extension of a layer of the second reflective element and wherein a size of the structures of the plurality of structures and/or a distance between adjacent structures is smaller than the laser wavelength.

3. The light emitting unit according to any of the preceding claims, wherein the gain element comprises a plurality of structures spaced apart in a direction of an extension of a layer of the gain element and wherein a size of the structures of the plurality of structures and/or a distance between adjacent structures is smaller than the laser wavelength.

4. The light emitting unit according to any of the preceding claims, further comprising a first spacer element arranged between the gain element and the second reflective element, the first spacer element being configured to provide a desired distance between the first reflective element and the second reflective element.

5. The light emitting unit according to any of the preceding claims, wherein the beam shaping element is a separate element and wherein the beam shaping element and the gain element are arranged on opposite sides of the second reflective element.

6. The light emitting unit according to claim 5, further comprising a second spacer element arranged between the second reflective element and the beam shaping element, the second spacer element being configured to provide a desired distance therebetween.

7. The light emitting unit according to any of the preceding claims, further comprising a tunable element integrated with the stack of layers on the substrate, the tunable element being configured to provide tunability to the laser light.

8. The light emitting unit according to any of the preceding claims, wherein the substrate comprises Germanium.

9. The light emitting unit according to any of the preceding claims, further comprising a first electrode and a second electrode integrated with the stack of layers on the substrate, wherein the first electrode and the second electrode are arranged on opposite sides of the gain element in the stack of layers, and wherein the first electrode and the second electrode are configured to generate a population inversion in the gain element.

10. The light emitting unit according to claim 9, further comprising a first contact and a second contact, the first contact and the second contact extending through at least some of the layers in the stack, and being connected to the first electrode and the second electrode, respectively, wherein the first contact and the second contact enable electric control of the light emitting unit, and wherein at least one of the first contact and the second contact has a cross-sectional width of less than 1 µm.

11. The light emitting unit according to any of the preceding claims, wherein the first reflective element, the gain element, and the second reflective element respectively, are arranged along an optical axis such that a center of the first reflective element, the gain element, and the second reflective element respectively, does not deviate from the optical axis by more than 100 nm, and wherein the optical axis extends in a direction perpendicular to the planar surface of the substrate.

12. A light emitting device comprising:
a substrate comprising a planar surface;
an array of light emitting units according to any of the preceding claims, the array of light emitting units being arranged on the planar surface of the substrate.

13. The light emitting device according to claim 12, wherein the array of light emitting units has a pitch of light emitting units of less than 1000 µm, preferably less than 100 µm, and most preferably less than 60 µm.

14. A method for manufacturing a light emitting unit on a substrate comprising a planar surface, the light emitting unit being configured for emitting laser light at a laser wavelength, the method comprising:
forming a light emitting unit arranged on the planar surface of the substrate, wherein the forming of the light emitting unit comprises:
forming a first reflective element;
forming a gain element by epitaxial deposition on the first reflective element;
forming a second reflective element;
wherein the first reflective element, the gain region, and the second reflective element form a stack of layers integrated onto the planar surface of the substrate, wherein each layer in the stack of layers is parallel with the planar surface, and wherein the gain element is formed to be arranged between the first reflective element and the second reflective element,
wherein the forming of the light emitting unit further comprises:
forming a beam shaping element integrated with the stack of layers on the substrate, the beam shaping element being configured to shape the laser light being emitted, wherein the beam shaping element is a separate element to the first reflective element, the gain element and the second element or forms part of one or more of the first reflective element, the gain element and the second element;
wherein the forming of the beam shaping element involves lithography for forming a plurality of structures spaced apart in a direction of an extension of a layer of the beam shaping element such that a size of the structures of the plurality of structures and/or a distance between adjacent structures is smaller than the laser wavelength.

15. The method according to claim 14, wherein substrate is a wafer having a width of at least 200 mm.
